(19) **Europäisches Patentamt**
**European Patent Office**
**Office européen des brevets**

(11) **EP 2 528 231 B1**

(12) **EUROPEAN PATENT SPECIFICATION**

(45) Date of publication and mention
of the grant of the patent:
**10.10.2018 Bulletin 2018/41**

(21) Application number: **11734588.4**

(22) Date of filing: **14.01.2011**

(51) Int Cl.:
***H03H 17/06*** (2006.01)

(86) International application number:
**PCT/JP2011/050543**

(87) International publication number:
**WO 2011/089981 (28.07.2011 Gazette 2011/30)**

(54) **SIGNAL GENERATION DEVICE AND SIGNAL GENERATION METHOD**

SIGNALERZEUGUNGSVORRICHTUNG UND SIGNALERZEUGUNGSVERFAHREN

DISPOSITIF DE GÉNÉRATION DE SIGNAUX ET PROCÉDÉ DE GÉNÉRATION DE SIGNAUX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.01.2010 JP 2010009070**

(43) Date of publication of application:
**28.11.2012 Bulletin 2012/48**

(73) Proprietor: **Mitsubishi Electric Corporation
Tokyo 100-8310 (JP)**

(72) Inventors:
• **SANO, Hiroyasu
Tokyo 100-8310 (JP)**

• **TOMITSUKA, Koji
Tokyo 100-8310 (JP)**

(74) Representative: **Pfenning, Meinig & Partner mbB
Patent- und Rechtsanwälte
Theresienhöhe 11a
80339 München (DE)**

(56) References cited:
**JP-A- 3 283 810        JP-A- H0 221 712
JP-A- 10 065 494        JP-A- 11 191 724
JP-A- 2002 271 174      JP-A- 2009 232 079
US-A- 6 014 682         US-A1- 2002 140 853
US-A1- 2006 179 095     US-B1- 7 072 429**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field

The present invention relates to a signal generation device and a signal generation method that generate a signal whose sampling frequency has been converted based on a sampled input signal.

Background

In radio communications and the like, sampling frequency conversion is sometimes performed for converting a signal having been sampled at one sampling frequency, into a signal having been sampled at another sampling frequency. A conventional sampling-frequency conversion method is explained below. A case of performing sampling frequency conversion by using an oversampling polyphase filter is explained here.

The oversampling polyphase filter is a filter used for generating a signal whose sampling frequency has been increased M times, and in order to form a filter H having desired filter characteristics, M filter banks for which a tap coefficient is respectively set are used. By selecting a signal output from each filter bank periodically at an equal time interval and providing the selected signal as an output signal, a filtering process and the sampling frequency conversion can be performed.

For example, when M is 4, an input signal sampled at a predetermined sampling interval is input to each of M (four) sub-filters. The tap coefficients of the four sub-filters are obtained by extracting the tap coefficients of the desired filter H at an equal interval so that an origin of extraction is shifted for each filter. When the four sub-filters are represented as F1 to F4 and sets of the tap coefficients of F1 to F4 are $H_0$={h(0,0), h(0,1), h(0,2), h(0,3), h(0,4)}, H1={h(1,0), h(1,1), h(1,2), h(1,3), h(1,4)}, H2={h(2,0), h(2,1), h(2,2), h(2,3), h(2,4)}, and H3={h(3,0), h(3,1), h(3,2), h(3,3), h(3,4)}, respectively, an impulse response of the filter H corresponding to 4-times oversampling becomes {h(0,0), h(1,0), h(2,0), h(3,0), h(0,1), h(1,1), ···}. In this case, an FIR filter is assumed, and the tap coefficients of each filter bank are set based on the impulse response of the filter H corresponding to the 4-times oversampling.

As described above, by setting the tap coefficients of the filter banks corresponding to characteristics of the filter H and sequentially selecting the outputs from the four filter banks, which are F1, F2, F3, and F4, at an equal time interval within a sampling period of the input signal, it is possible to obtain an output signal whose sampling frequency has been converted into a four-times higher frequency.

PTL1 describes methods and apparatus for variable-rate down-sampling filters for discrete-time sampled systems using a fixed sampling rate. The Variable Rate Down-Sampling Filter allows a continuous range of sample rates to be derived from input samples at a fixed rate. The output rate does not have to be related to the fixed input rate in any integral or rational way, and in fact, the output rate can vary in time such as will occur when tracking a signal received from a station using a different timebase. A fixed sampling rate at the A/D Converter greatly simplifies the design of the analog front end. A single anti-aliasing filter can be designed and precisely matched to the fixed sampling rate. Used with a frequency-modulated numerically controlled oscillator (NCO), the Down-Sampling Filter keeps the entire frequency-synthesis and time-tracking loop in the digital domain. The need for an analog time-tracking loop to adjust the sampling instant at the A/D converter is eliminated. The need for an analog frequency synthesizer to generate a variable sampling rate is also eliminated. System design and performance analysis are simplified as well by eliminating the complication of hybrid analog-digital control loops. Details are disclosed.

PTL2 describes how to obtain an output sample string with high accuracy by applying prediction calculation to a ratio of each of an input sampling period and an output sampling period to a local clock period by means of the accumulation processing of errors and applying the interpolation processing to an input sample string based on a filter coefficient address data obtained through the accumulation of divided values.

PTL3 describes an asynchronous sample rate converter (ASRC) for the conversion of the sample rate of digital data such as audio data or video data. In the case of high over-sampling or sub-sampling factors an ASRC becomes quite complex. It is an object of the invention to provide an ASRC with a simplified design for such purposes. It is suggested to use an ASRC which has a n-tap polyphase filter, whereby a computational entity performs a polynomial computation of the filter coefficients. The attenuation at the notch frequencies is best when using a Parzen window or a quadratic window.

PTL 4 describes sampling rate conversion apparatus and method of converting the sampling rate of an input signal by supplying an interpolation filter with interpolated data obtained by interpolating data based on a prototype filter according to conversion rate as its coefficients. The sampling rate conversion apparatus includes an interpolator interpolating predetermined data based on a prototype filter according to conversion rate to obtain a desired filter coefficient, and a sampling rate converter performing interpolation filtering on an input signal by the filter coefficient supplied from the interpolator. Therefore, coefficients of an interpolation filter adaptable to various conversion rates can be provided without using a large on-chip memory, thereby attaining a superb interpolated version for the input signal.

In PTL 5 a first series of filter coefficients stored in a memory itself corresponds to a given filter characteristic such as a given high cutoff frequency. A second series of filter coefficients is generated by performing an interpolation process on the first series of filter coefficients. At that time, the contents, such as interpolation coefficients, of the interpolation process are varied in correspondence to a desired filter characteristic to be achieved, so that the interpolation process generates a second series of filter coefficients according to an impulse response characteristic that is obtained as a consequence of expanding or compressing, in a time-axis direction, an impulse response characteristic represented by the given first series of the filter coefficients. Thus, by the interpolation process, there is produced such a second series of filter coefficients that achieves a different filter characteristic (e.g., different high cutoff frequency). Where the sampling frequency of a time series of digital signals is to be changed from a given first frequency to a second frequency, an aliasing noise frequency may vary depending on a value of the first or second sampling frequency, in which case it is necessary to vary the cutoff frequency of a filter for eliminating the aliasing noise. However, by performing the interpolation process in the above-noted manner, the filter characteristic for eliminating the aliasing noise can be varied as desired.

Citation List

Non Patent Literature

Non Patent Literature 1: Nishimura, "Communication system design by digital signal processing", CQ Publishing Co., Ltd., pp. 79-89 (June 2006)

Patent Literature

Patent Literature 1 (PTL1): US 6 014 682 A
Patent Literature 2 (PTL2): JP H02 21712 A
Patent Literature 3 (PTL3): US 2006/179095 A1
Patent Literature 4 (PTL4): US 2002/140853 A1
Patent Literature 5 (PTL5): US 7 072 429 B1

Summary

Technical Problem

However, according to the conventional sampling frequency conversion method using a polyphase filter, there is a problem that, when an output signal is converted into an arbitrary sampling frequency, it is necessary to change the sampling frequency of an input signal as well as a frequency of an operation clock used for the sampling conversion.
Furthermore, to set the sampling frequency of the output signal to an arbitrary value when the operation clock frequency is fixed, it is necessary to use a plurality of polyphase filters for the oversampling and downsampling in combination. Therefore, there is a problem that the number of arithmetic operations is increased, and a memory size becomes large because the number of candidates of the tap coefficients of the polyphase filters is increased.
Further, in order to set the sampling frequency of the output signal to an arbitrary value when the operation clock frequency is fixed, it is necessary to use a plurality of filter banks corresponding to the sampling frequency of the output signal when the polyphase filters are constituted, and this causes a problem that the number of arithmetic operations is increased and a circuit size is enlarged.
Furthermore, in the prior art the output sample signal cannot be smoothly varied continuously.
The present invention has been achieved in view of the above problems, and an object of the present invention is to provide a signal generation device that can perform sampling frequency conversion at an arbitrary rate with a simple configuration, wherein the output sample signal is smoothly varied continuously, and a signal generation method. Solution to Problem
In order to solve the above problem and in order to attain the above object, a signal generation device of the present invention is provided, as defined in claim 1 and in the correspoding method according to claim 13.

Advantageous Effects of Invention

According to the signal generation device and the signal generation method of the present invention, it is possible to perform sampling frequency conversion at an arbitrary rate with a simple configuration, wherein the output sample signal is smoothly varied continuously.

Brief Description of Drawings

FIG. 1 is an example of a functional configuration of a signal generation device according to a first embodiment of the invention, generically described in figure 10.
FIG. 2 is a configuration example of filter banks.
FIG. 3 is an example of a switching operation of a switching unit.
FIG. 4-1 is an example of tap coefficients corresponding to an impulse response of a desired filter characteristic H in 16-times oversampling.
FIG. 4-2 is an example of a set ($H_0$) of tap coefficients of a filter bank.
FIG. 4-3 is an example of a set ($H_4$) of tap coefficients of a filter bank.
FIG. 4-4 is an example of a set ($H_8$) of tap coefficients of a filter bank.

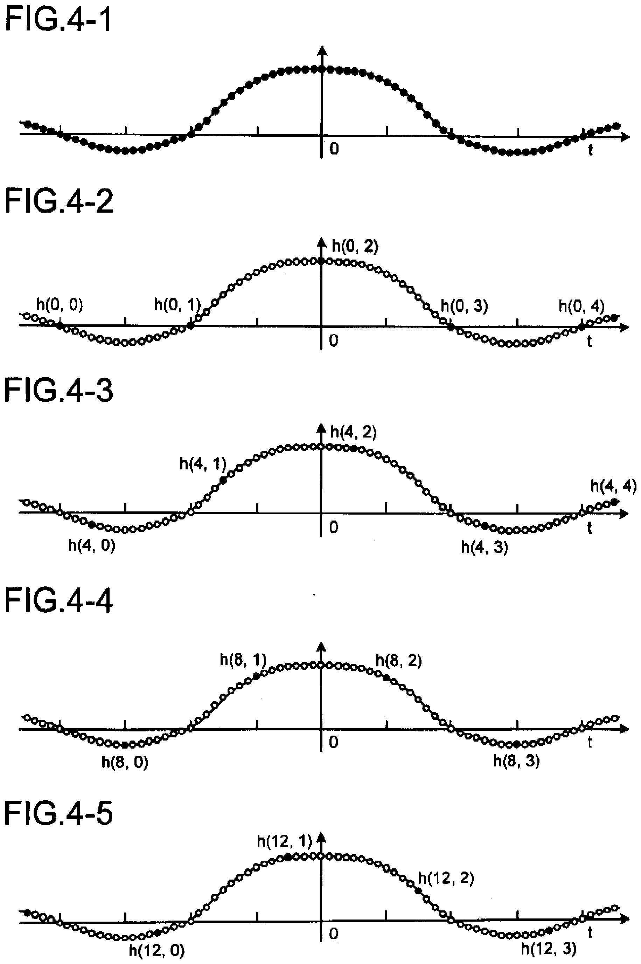

FIG. 4-5 is an example of a set ($H_{12}$) of tap coefficients of a filter banks.

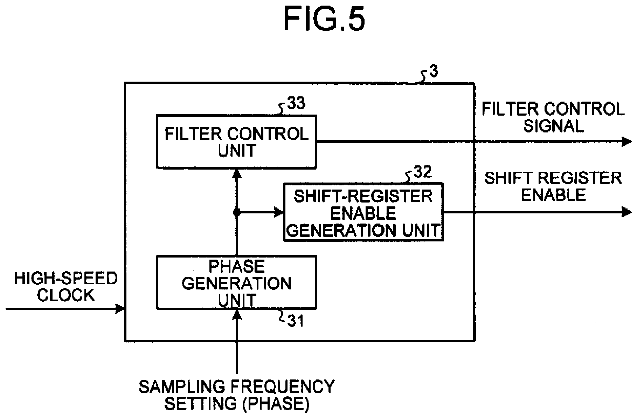

FIG. 5 is a configuration example of a control-signal generation unit.

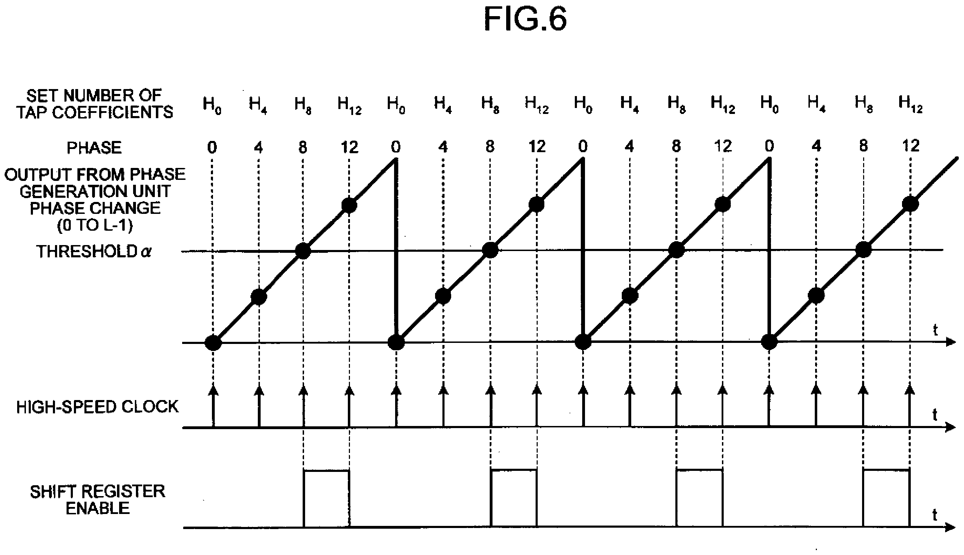

FIG. 6 is an example of an operation in a case where a ratio between a high-speed clock frequency and a sampling frequency of an output signal is four times.

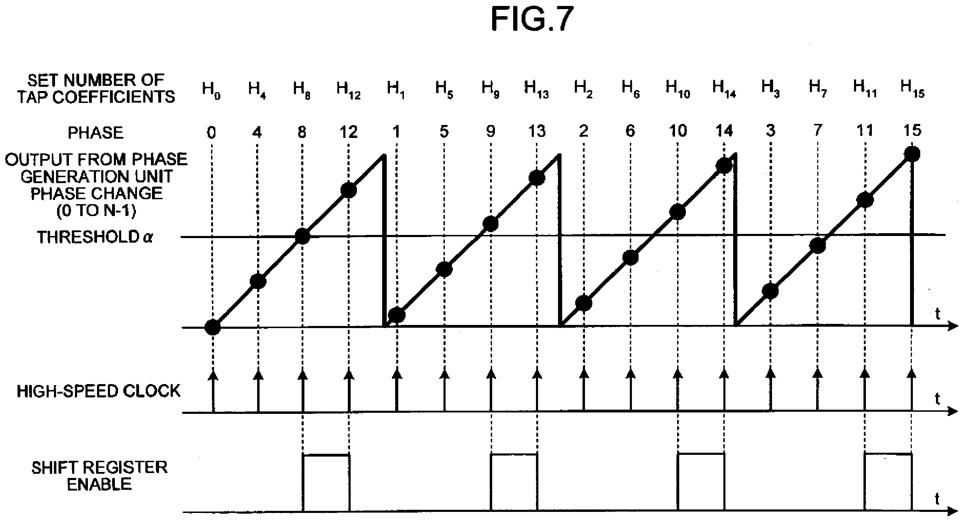

FIG. 7 is an example of an operation in a case where a ratio between a high-speed operation clock frequency and a sampling frequency of an output signal is smaller than four times.

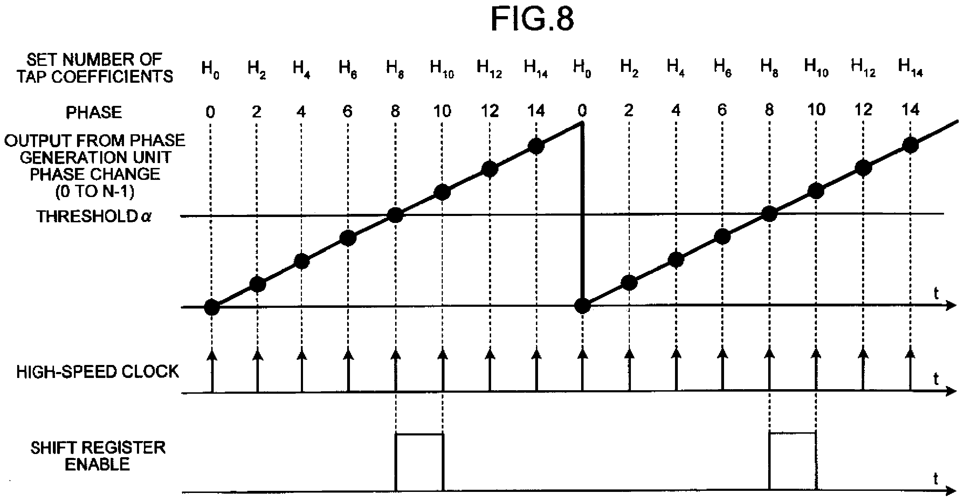

FIG. 8 is an example of an operation in a case where a ratio between a high-speed operation clock frequency and a sampling frequency of an output signal is eight times.

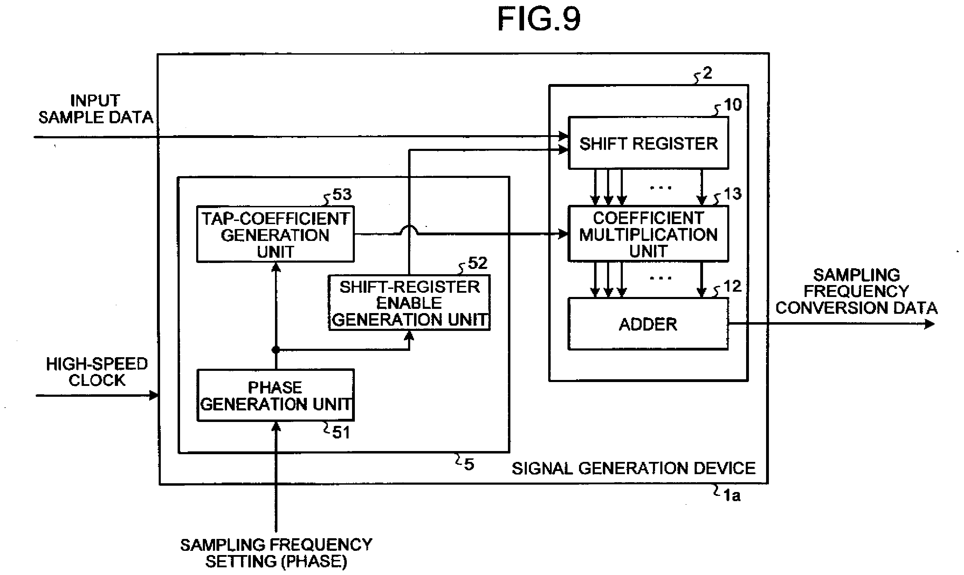

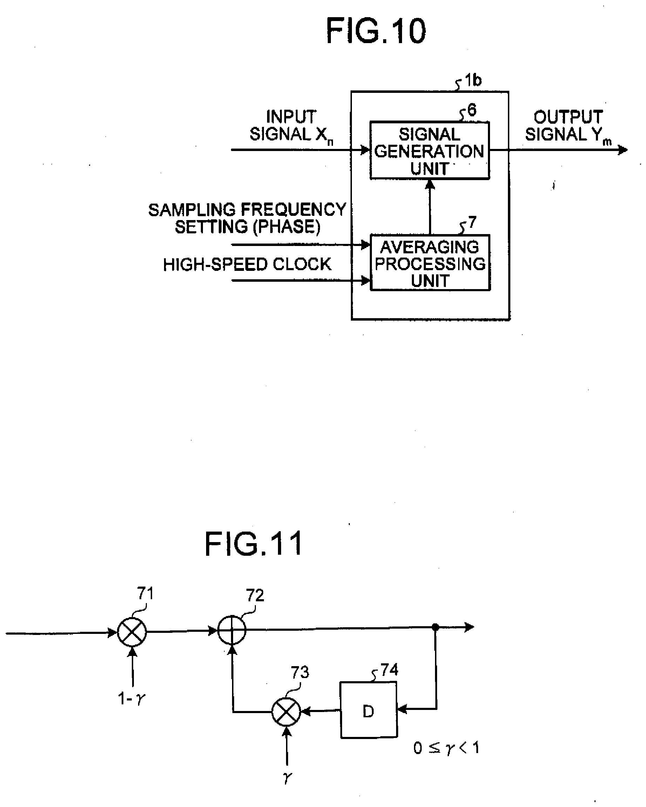

FIG. 9 is an example of a functional configuration of a signal generation device according to a second embodiment of the invention, generically described in figure 10.
FIG. 10 is an example of a functional configuration of a signal generation device according to the invention.
FIG. 11 is an example of a configuration of an averaging processing unit.

Description of Embodiments

Exemplary embodiments of a signal generation device and a signal generation method according to the present invention will be explained below in detail with reference to the accompanying drawings. The present invention is not limited to the embodiments.

First embodiment.

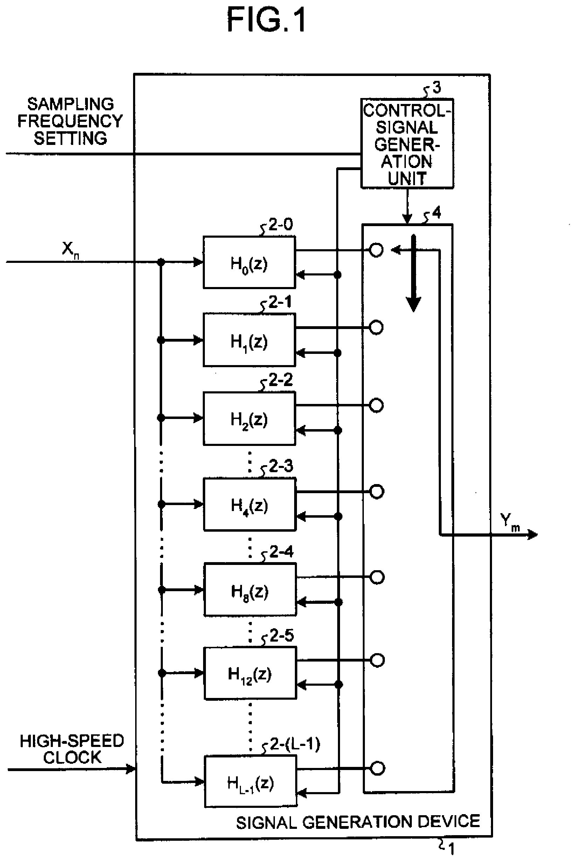

FIG. 1 is an example of a functional configuration of a signal generation device according to a first embodiment of the present invention. A signal generation device 1 according to the present embodiment performs a sampling-frequency conversion process on an input signal $X_n$ (n indicates a sampling number) of a predetermined sampling frequency, and then outputs a signal $Y_m$ (m indicates a sample number given after the sampling-frequency conversion process) obtained after the sampling-frequency conversion process.

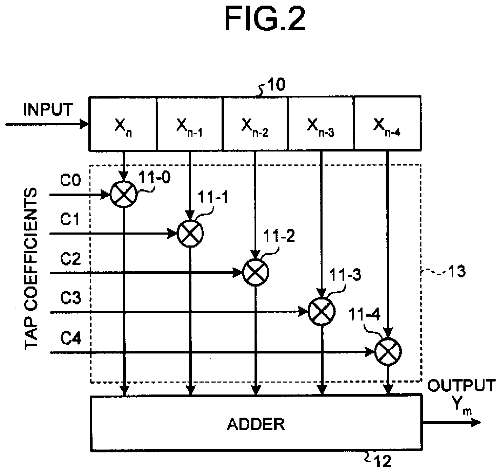

As shown in FIG. 1, the signal generation device 1 according to the present embodiment includes filter banks 2-0 to 2-(L-1) (L is an integer equal to or larger than 1), a control-signal generation unit (control unit) 3, and a switching unit 4. FIG. 2 is a configuration example of the filter banks 2-0 to 2-(L-1). While a case where the filter banks 2-0 to 2-(L-1) respectively use five tap coefficients is exemplified here, the number of the tap coefficients is not limited thereto. The filter banks 2-0 to 2-(L-1) have a configuration identical to each other, and are respectively constituted by a shift register 10, multipliers 11-0 to 11-4, and an adder 12. The multipliers 11-0 to 11-4 constitute a coefficient multiplication unit 13.

The configuration of the filter banks 2-0 to 2-(L-1) is identical to that of a general FIR (Finite Impulse Response) filter. The shift register 10 generates signals $X_n$, $X_{n-1}$, $X_{n-2}$, $X_{n-3}$, and $X_{n-4}$ that have been delayed from the input signal $X_n$ by one sample relative to each other. The multiplier 11-0 multiplies $X_n$ by a tap coefficient C0, the multiplier 11-1 multiplies $X_{n-1}$ by a tap coefficient C1, the multiplier 11-2 multiplies $X_{n-2}$ by a tap coefficient C2, the multiplier 11-3 multiplies $X_{n-3}$ by a tap coefficient C3, and the multiplier 11-4 multiplies $X_{n-4}$ by a tap coefficient C4. The adder 12 adds outputs from the multipliers 11-0 to 11-4 together, and then outputs them to the switching unit 4.

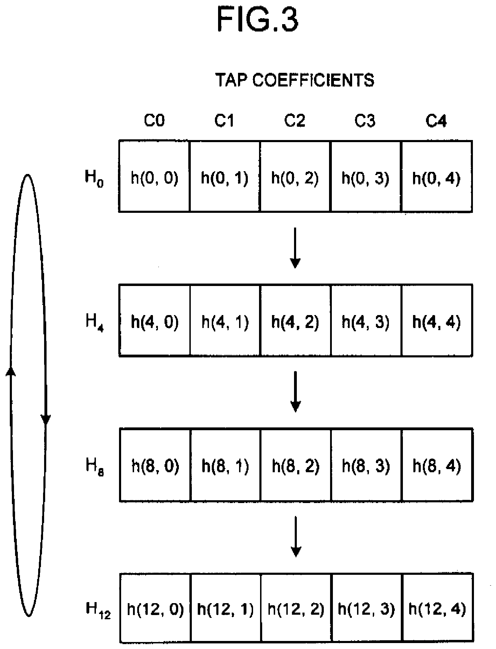

FIG. 3 is an example of a switching operation of the switching unit 4. FIGS. 4-1 to 4-5 are an example of tap coefficients of filter banks. The examples of the switching operation shown in FIG. 3 and FIGS. 4-1 to 4-5 represent a case where L is 16 (resolution of 16-times oversampling) and a case where a ratio between a high-speed operation clock frequency fclk and a sampling frequency fout of the output signal (fclk/fout) is 4.

Generally, in frequency conversion using a conventional polyphase filter, the operation clock frequency is the same as a sampling frequency of an output signal (a converted sampling frequency obtained after sampling frequency conversion), and by switching the filter banks based on the operation clock (switching among the filter banks to be selected as the output signal), the output signal of the converted sampling frequency can be generated.

On the other hand, in the present embodiment, the sampling frequency fout of a plurality of output signals is handled while the high-speed operation clock frequency fclk is fixed, and therefore fclk and fout are not necessarily the same. Accordingly, in the present embodiment, the filter banks to be selected are changed according to the ratio fclk/fout. In this example, L is 16, and the sampling frequency can be converted into a maximum frequency of 16 times with respect to the input signal $X_n$. Therefore, it suffices that the high-speed operation clock frequency fclk is higher than the sampling frequency 16 times as high as that of the input signal, and in this example, the high-speed clock frequency fclk is the sampling frequency 16 times as high as the input signal. In addition, in this example, the sampling frequency of the input signal $X_n$ is fixed.

Based on the above assumption, when the ratio fclk/fout is 4, the sampling frequency four times as high as that of the input signal is obtained after conversion. Thus, four filter banks are used for the sampling frequency conversion. In this example, four of the filter banks 2-0, 2-4, 2-8, 2-12 (H0, H4, H8, H12) are to be selected. For the filter banks 2-0 to 2-(L-1), it is assumed that sets of the tap coefficients $H_0$ to $H_{L-1}$, which are obtained by extracting the tap coefficients of a desired filter characteristic H that correspond to each filter bank, are set. In this example, because the number of taps is five, the number of the tap coefficients set for each filter bank is five (C0, C1, C2, C3, and C4) .

Accordingly, the tap coefficients can be represented as $H_0$={h(0,0), h(0,1), h(0,2), h(0,3), h(0,4)}, $H_1$={h(1,0), h(1,1), h(1,2), h(1,3), h(1,4)}, $H_2$={h(2,0), h(2,1), h(2,2), h(2,3), h(2,4)}, ···, $H_4$={h(4,0), h(4,1), h(4,2), h(4,3), h(4,4) }, ···, $H_{15}$={h(15,0), h(15,1), h(15,2), h(15,3), h(15,4)}. Furthermore, $H_0$ to $H_{L-1}$ are sets of tap coefficients that are extracted at an equal interval (an interval of L) from all the tap coefficients corresponding to the desired filter characteristic H so that an origin of the tap coefficients of each filter is shifted by one point from each other, and that are obtained by polyphase decomposition of the desired filter characteristic H.

FIG. 3 depicts a switching operation among the selected four filter banks 2-0, 2-4, 2-8, and 2-12 (corresponding to $H_0$, $H_4$, $H_8$, and $H_{12}$, respectively) in sequence. FIG. 4-1 is an example of all the tap coefficients corresponding to an impulse response of the desired filter characteristic H in the 16-times oversampling, FIG. 4-2 depicts a set ($H_0$) of the tap coefficients of the filter bank 2-0, FIG. 4-3 depicts a set (H4) of the tap coefficients of the filter bank 2-4, FIG. 4-4 depicts a set ($H_8$) of the tap coefficients of the filter bank 2-8, and FIG. 4-5 depicts a set ($H_{12}$) of the tap coefficients of the filter bank 2-12.

As shown in FIGS. 4-1 to 4-5, the tap coefficients of the filter banks 2-0, 2-4, 2-8, and 2-12 are those extracted from all the tap coefficients at an equal interval (an interval of L) so that the origin of the tap coefficients of each filter is shifted by four points from each other. Accordingly, as shown in FIG. 3, the switching unit 4 switches among the filter banks 2-0, 2-4, 2-8, and 2-12 at a time interval corresponding to fout, thereby generating the output signal $Y_m$ of the sampling frequency one-fourth fclk.

In the present embodiment, the sampling frequency fout of the output signal is set in the control-signal generation unit 3, the control-signal generation unit 3 generates a control signal transmitted to the switching unit 4 based on fout as described later, and the switching unit 4 switches among the filter banks to be selected based on the control signal. Processing of the control-signal generation unit 3 is explained below.

FIG. 5 is a configuration example of the control-signal generation unit 3. As shown in FIG. 5, the control-signal generation unit 3 is constituted by a phase generation unit 31, a shift-register enable generation unit 32, and a filter control unit 33.

The control-signal generation unit 3 operates on a high-speed operation clock (the frequency fclk). A sampling-frequency setting (phase), which is a value determined by a ratio between the high-speed clock frequency and an output sampling frequency, is input to the control-signal generation unit 3. It is assumed that the output sampling frequency is input to the control-signal generation unit 3, so that the control-signal generation unit 3 can calculate the sampling frequency setting (phase). A sampling frequency setting (phase) $\Delta P$ is a value obtained by a calculation of the following expression (1). Note that $\Delta P$ does not necessarily need to be an integer.

$$\Delta P = L/(fclk/fout) \qquad \cdots (1)$$

In this example, the ratio fclk/fout is 4, and the sampling frequency setting (phase) $\Delta P$ becomes 4 accordingly.

In the present embodiment, a phase of 0 to $2\pi$ is expressed as a value having been converted into a linear value of 0 to (L-1), and $\Delta P$ is expressed as a converted phase. Based on the input sampling frequency setting (phase), the phase generation unit 31 integrates the phase and outputs as an output phase a result (0 to (L-1)) obtained by applying modulo-L arithmetic to the integral.

Specifically, the phase generation unit 31 determines an output phase P(k) from the following expression (2) based on $\Delta P$, for example. Note that an initial value S(0) is 0.

$$S(k)=F\{S(k-1)+\Delta P\}$$

$$P(k)=modulo\{S(k),\ L\} \qquad \cdots(2)$$

Reference sign $F(\cdot)$ denotes a function used for rounding off fractions, and k denotes a sample number of the output signal. Accordingly, it suffices to calculate P(k) once for every 4 (=fclk/fout) pulses of a high-speed clock. Note that $F(\cdot)$ can be a function for rounding down the fractions for simplicity of the arithmetic operation.

The phase generation unit 31 outputs the output phase P(k) to the shift-register enable generation unit 32 and the filter control unit 33. Based on the output phase P(k), the filter control unit 33 selects the filter bank 2-j determined from j=P(k) every time P(k) is updated (that is, once for 4 (=fclk/fout) periods of the high-speed clock), and outputs to the switching unit 4 a control signal for instructing to output the signal $Y_m$ (m is the sample number) having the filtering processing of the selected filter bank 2-j performed thereon. The switching unit 4 performs switching of filter banks based on this control signal.

Based on the output phase P(k), the shift-register enable generation unit 32 generates a shift-register enable pulse for instructing updating of contents in the shift register 10 of the filter banks 2-0 to 2-(L-1). Based on the shift-register enable pulse, the filter banks 2-0 to 2-(L-1) update a value of the shift register 10 to another value derived from the next (next sample) input signal. A method of generating the shift-register enable pulse of the shift-register enable generation unit 32 can be any method as long as it is for generating a shift-register enable pulse once for every sampling period of an input signal. As an example, it is assumed that the output phase P(k) is compared to a predetermined threshold $\alpha$ in the unit of high-speed clock cycles, and when P(k) becomes equal to or larger than $\alpha$, a pulse is generated at every high-speed clock unit.

FIG. 6 is an example of an operation in a case where the ratio between the high-speed clock frequency and the sampling frequency of the output signal is four times. In FIG. 6, an arrow of the high-speed clock indicates one period out of four high-speed clock periods, and at the clock indicated by the arrow (once in four times), the filter banks 2-0 to 2-(L-1) are selected, and then the output signal from the selected filter banks 2-0 to 2-(L-1) is output as an output signal obtained after the sampling conversion. FIG. 6 depicts set numbers ($H_0$, $H_4$, $H_8$, and $H_{12}$) of the tap coefficients of the selected filter banks 2-j and the output phase at the specific time (the phase in FIG. 6).

Furthermore, $\alpha$ is L/2=8 in FIG. 6, and when P(k) becomes 8, the shift-register enable pulse is changed from Low to High. In FIG. 6, the shift-register enable pulse continues between the arrows (four units of the high-speed clock); however, in practice, it suffices to bring the shift-register enable pulse into High at one high-speed clock unit. Further, the value of $\alpha$ is not limited to 8, and can be any value between 0 to L-1.

FIG. 7 is an example of an operation in a case where the ratio between the high-speed operation clock frequency and the sampling frequency of the output signal is smaller than four times. FIG. 7 is an operation example in a case where L is 16, the ratio fclk/fout between the high-speed operation clock frequency and the sampling frequency of the output signal is slightly smaller than 4, and $\Delta P$ is 4+b, which is slightly larger than 4 (for example, 0.5/4≤b<0.5/3).

In the case of the example in FIG. 7, the output phase P(k) calculated by the expression (2) is the same as that in the example in FIG. 6 on the first four points because the fractions of S(k) are rounded off. For example, S(0) is 0 (initial value) on the first point, S(3) is $3\times\Delta P=3\times(4+b)$ on the fourth point, and thus P(3) is 12. Meanwhile, on the fifth point, 16 is obtained by rounding off S(4), which is $4\times\Delta P=4\times(4+b)$. Therefore, P(4)=1 is established, and this means j=1 on the fifth point and thus the filter bank 2-1 (the set number $H_1$ of the tap coefficients) is selected. In this manner, the filter banks to be selected are subsequently changed, such as the filter banks 2-5, 2-9, 2-13, 2-2, 2-6, ···, for every sampling period of the input signal.

As described above, in the present embodiment, S(k) is set to be an integer (by rounding off or rounding down the number), and then the filter bank to be selected is determined, thereby handling a case where the ratio between the high-speed operation clock frequency and the sampling frequency of the output signal is not an integral multiple. Therefore, even with a limited number of filter banks, it is possible to correspond to the sampling frequency of any output signal with a small error.

FIG. 8 is an example of an operation in a case where the ratio between the high-speed operation clock frequency and the sampling frequency of the output signal is eight times. In FIG. 8, because L is 16 and the ratio fclk/fout is 8, FIG. 8 corresponds to a case of converting an output signal into an output signal of the sampling frequency one-eighth the high-speed operation clock frequency. In this case, $\Delta P$ is 2, and by switching the eight filter banks 2-0, 2-2, 2-4, 2-6, 2-8, 2-10, 2-12, and 2-14 sequentially, the output signal of the sampling frequency one-eighth the high-speed operation clock frequency is generated.

In the present embodiment, $\Delta P$ is used to determine the filter banks 2-0 to 2-(L-1) to be selected; however, other methods not using $\Delta P$ can be employed as long as selecting (switching) similar to that of the above method is performed based on the ratio between the high-speed operation clock frequency and the sampling frequency of the output signal.

When the filter banks 2-0 to 2-(L-1) and the switching unit 4 in the present embodiment are assumed as a single filtering unit, the control-signal generation unit 3 can be deemed to give this filtering unit an instruction of sets of the tap coefficients that are set for the filter banks 2-0 to 2-(L-1) selected as the output signal, when the filter banks 2-0 to 2-(L-1) are selected.

In the present embodiment, the filter banks 2-0 to 2-(L-1) to be selected are determined based on $\Delta P$, which is the ratio between the high-speed operation clock frequency and the sampling frequency of the output signal; however, a method of determining the filter banks is not limited thereto and can be any method as long as it determines the filter banks 2-0 to 2-(L-1) based on the sampling frequency of the output signal.

As described above, in the present embodiment, the high-speed operation clock frequency is fixed, L filter banks 2-0 to 2-(L-1) corresponding to a maximum oversampling ratio L are provided, the phase generation unit 31 determines and gives an instruction for the filter banks 2-0 to 2-(L-1) to be selected, based on the ratio between the high-speed operation clock frequency and the sampling frequency of the output signal, and the switching unit 4 selects an output from the filter banks 2-0 to 2-(L-1) based on the instruction, and then outputs the selected one. Therefore, without combining a plurality of polyphase filters for upsampling and downsampling and with a simple configuration, sampling frequency conversion can be performed at any oversampling ratio not exceeding a maximum oversampling ratio while a high-speed operation clock frequency is fixed.

Second embodiment.

FIG. 9 is an example of a functional configuration of a signal generation device according to a second embodiment of the present invention. A signal generation device 1a according to the present embodiment is constituted by a filter bank 2 and a control-signal generation unit 5. The filter bank 2 has a configuration identical to that of the filter banks 2-0 to 2-(L-1) according to the first embodiment. While L filter banks are provided in the first embodiment, the signal generation device 1a according to the present embodiment has one filter bank 2.

Differences from the first embodiment are explained below. The control-signal generation unit 5 is constituted by a phase generation unit 51, a shift-register enable generation unit 52, and a tap-coefficient generation unit (filter control unit) 53. In the present embodiment, it is assumed that an operation is performed at the high-speed clock fclk corresponding to a maximum oversampling ratio. In the second embodiment, the maximum oversampling ratio L (resolution) is explained as 16.

Similarly to the phase generation unit 31 according to the first embodiment, the sampling frequency setting (phase) $\Delta P$, which is determined based on the ratio between the high-speed clock frequency and the output sampling frequency, is input to the phase generation unit 51 of the control-signal generation unit 5. The method of calculating $\Delta P$ is the same as that in the first embodiment. When L is 16 and the ratio fclk/fout is 4, $\Delta P$ is 4. The phase generation unit 51 determines the output phase $P(k)$ similarly to the phase generation unit 31 in the first embodiment, and then outputs to the shift-register enable generation unit 52 and the tap-coefficient generation unit 53.

An operation of the shift-register enable generation unit 52 is identical to that of the shift-register enable generation unit 32 according to the first embodiment. The tap-coefficient generation unit 53 holds the sets of the tap coefficients $H_0$ to $H_{12}$ shown in the first embodiment. The tap-coefficient generation unit 53 selects the set $H_j$ of the tap coefficients corresponding to j=P(k) based on the output phase $P(k)$, and then outputs the selected set of the tap coefficients to the coefficient multiplication unit 13 of the filter bank 2. The coefficient multiplication unit 13 of the filter bank 2 sets the set of the tap coefficients output from the tap-coefficient generation unit 53 as the tap coefficients (C0 to C4). A signal having the filtering using the set of the tap coefficients $H_j$ performed thereon is output from the filter bank 2, as the output signal $Y_m$ obtained after the sampling frequency conversion. Operations of the present embodiment except for those explained above are identical to those of the first embodiment.

As described above, in the present embodiment, one filter bank 2 is provided, the tap-coefficient generation unit 53 holds the sets of the tap coefficients $H_0$ to $H_{12}$, the set of the tap coefficients is selected based on $P(k)$ calculated similarly to the first embodiment, and the coefficient multiplication unit 13 in the filter bank 2 sets the selected set of the tap coefficients. Therefore, the use of even one filter bank can achieve effects identical to those of the first embodiment, so that the configuration in the present embodiment can be simplified as compared to the first embodiment.

Third embodiment.

FIG. 10 is an example of a functional configuration of a signal generation device according to the present invention. A signal generation device 1b according to the invention is constituted by a signal generation unit 6 and an averaging processing unit 7. The signal generation unit 6 has a configuration identical to that of the signal generation device 1 according to the first embodiment or that of the signal generation device 1a according to the second embodiment.

In the invention, the sampling frequency setting (phase) $\Delta P$ is averaged and then input to the control-signal generation unit 3 according to the first embodiment or the control-signal generation unit 5 according to the second embodiment. While any configuration and method can be used for the configuration of the averaging processing unit 7 and for the averaging method thereof, in the present embodiment, an example of using an IIR (Infinite Impulse Response) filter is explained.

FIG. 11 is an example of the configuration of the averaging processing unit 7. As shown in FIG. 11, the averaging processing unit 7 is constituted by a multiplier 71, an adder 72, a multiplier 73, and a delay unit (D) 74. Note that $\gamma(0 \leq \gamma < 1)$ is a gain for setting smoothing of a filter. Because processing of the averaging processing unit 7 is identical to that of a general IIR filter, explanations thereof will be omitted. The averaging processing unit 7 is not limited to this configuration, and can be realized by other configurations such as that using primary and secondary loop filters. Operations of the present embodiment except for those explained above are identical to those of the first or second embodiment.

In the present embodiment, it is assumed that $\Delta P$ is input to the phase generation unit 51 and is averaged; however, when the sampling frequency of the output signal is input to the phase generation unit 51, the sampling frequency of the output signal is averaged.

As described above, in the present embodiment, by averaging the sampling frequency setting (phase) $\Delta P$ in advance, $\Delta P$ can be smoothly varied and the output sample signal can be also smoothly varied continuously. Therefore, in the present invention, when noise and the like are added on the sampling frequency setting (phase) or when the sampling frequency setting (phase) is changed at a midpoint, it is possible to smoothly vary the output signal.

Industrial Applicability

As described above, the signal generation device and the signal generation method according to the present invention are suitable for a signal generation device that generates a signal whose sampling frequency has been converted based on a sampled input signal, and are particularly suitable for a case where a converted sampling frequency of a signal is not fixed.

Reference Signs List

| | |
|---|---|
| 1, 1a, 1b | signal generation device |
| 2, 2-0 to 2-(L-1) | filter bank |
| 3, 5 | control-signal generation unit |
| 4 | switching unit |
| 6 | signal generation unit |
| 7 | averaging processing unit |
| 10 | shift register |
| 11-0 to 11-4 | multiplier |
| 12 | adder |
| 13 | coefficient multiplication unit |
| 31, 51 | phase generation unit |
| 32, 52 | shift-register enable generation unit |
| 33 | filter control unit |
| 53 | tap-coefficient generation unit |
| 71, 73 | multiplier |
| 72 | adder |
| 74 | delay unit |

**Claims**

**1.** A signal generation device (1) comprising:

a filtering unit (2-0 to 2-(L-1), 4) that performs sampling frequency conversion with respect to an input signal of a predetermined sampling frequency, and generates a signal obtained after the sampling frequency conversion as an output signal; and

a control unit (3) that selects, based on a sampling-frequency setting value indicating a sampling frequency of the output signal, a combination of tap coefficients used by the filtering unit (2-0 to 2-(L-1), 4) from a plurality of combinations of tap coefficients determined in advance, wherein

the filtering unit (2-0 to 2-(L-1), 4) performs the sampling frequency conversion based on a result of the selection by the control unit, the signal generation device further comprising an averaging processing unit (7) that averages the sampling-frequency setting value, wherein

the control unit (3) designates a sampling-frequency setting value averaged by the averaging processing unit (7) as the sampling-frequency setting value used to select tap coefficients to be used by the filtering unit (2-0 to 2-(L-1), 4).

2. The signal generation device (1) according to claim 1, wherein

the filtering unit (2-0 to 2-(L-1), 4) includes

a plurality of filters (2-0 to 2-(L-1)) for which different combinations of tap coefficients are respectively set, and

a switching unit (4) that selects one of the filters (2-0 to 2-(L-1)) based on an instruction of the control unit (3) so as to designate the selected filter as the output signal, and

the control unit (3) selects tap coefficients used by the filtering unit (2-0 to 2-(L-1), 4) by determining the filter to be selected by the switching unit (4), based on the sampling-frequency setting value.

3. The signal generation device (1) according to claim 1, wherein

the control unit (3) holds the combinations of tap coefficients, and selects tap coefficients used by the filtering unit (2-0 to 2-(L-1), 4) by selecting the combination of the tap coefficients, based on the sampling-frequency setting value,

the filtering unit (2-0 to 2-(L-1), 4) includes one filter, and

the filter performs the sampling frequency conversion using the combination of the tap coefficients selected by the control unit (3).

4. The signal generation device (1) according to claim 2 or 3, wherein the filter is an FIR filter.

5. The signal generation device (1) according to any one of claims 1 to 4, wherein the sampling-frequency setting value is a value calculated based on a ratio between an operation clock of the filtering unit (2-0 to 2-(L-1), 4) and the sampling frequency of the output signal.

6. The signal generation device (1) according to claim 5, wherein

the control unit (3) includes

a phase generation unit (31) that generates, based on the sampling-frequency setting value, a phase indicating a position of a combination of tap coefficients to be selected when the combinations of tap coefficients are arranged in a predetermined order, and

a filter control unit (3) that selects tap coefficients used by the filtering unit (2-0 to 2-(L-1)) based on the phase.

7. The signal generation device (1) according to claim 6, wherein the phase generation unit (31) generates the phase as a value such that a minimum value is 0 and a maximum value is a total number of the combinations of tap coefficients.

8. The signal generation device (1) according to claim 7, wherein the phase generation unit (31) generates the phase as a value obtained by rounding off or rounding down fractions.

9. The signal generation device (1) according to claim 6, 7, or 8, wherein the control unit (3) further includes a shift-register enable generation unit (52) that generates a shift-register enable signal for instructing an update timing of the input signal that is input to the filtering unit (2-0 to 2-(L-1), 4).

10. The signal generation device (1) according to claim 9, wherein the shift-register enable generation unit (52) generates the shift-register enable signal so as to instruct an update timing of the input signal when the phase becomes equal to or larger than a predetermined threshold.

11. The signal generation device (1) according to claim 1, wherein the averaging processing unit (7) is an IIR filter.

**12.** The signal generation device (1) according to any one of claims 1 to 11, wherein the combinations of the tap coefficients are determined by applying polyphase decomposition to an impulse response of a predetermined filtering characteristic.

**13.** A signal generation method in a signal generation device (1) including performing sampling frequency conversion with respect to an input signal of a predetermined sampling frequency, and generating a signal obtained after the sampling frequency conversion as an output signal, the method comprising:

a controlling step of selecting, based on a sampling-frequency setting value indicating a sampling frequency of the output signal, a combination of tap coefficients used by a filtering unit (2-0 to 2-(L-1), 4) from a plurality of combinations of the tap coefficients determined in advance; and

a sampling-frequency converting step of performing the sampling frequency conversion based on a result of the selection at the controlling step, the method further comprising the step of averaging the sampling-frequency setting value, wherein

in the controlling step a sampling-frequency setting value averaged in the averaging step is designated as the sampling-frequency setting value used to select tap coefficients.

## Patentansprüche

**1.** Signalerzeugungseinrichtung (1), umfassend:

eine Filtereinheit (2-0 bis 2-(L-1), 4), die Abtastfrequenzumwandlung in Bezug auf ein Eingangssignal einer vorherbestimmten Abtastfrequenz durchführt, und ein nach der Abtastfrequenzumwandlung erhaltenes Signal als ein Ausgangssignal erzeugt; und

eine Steuereinheit (3), die auf der Grundlage eines Abtastfrequenzeinstellungswerts, anzeigend eine Abtastfrequenz des Ausgangssignals, eine Kombination von Abgriffskoeffizienten, die von der Filtereinheit (2-0 bis 2-(L-1), 4) verwendet wird, aus einer Vielzahl von Kombinationen von Abgriffskoeffizienten, die im Voraus bestimmt werden, auswählt, wobei

die Filtereinheit (2-0 bis 2-(L-1), 4) Abtastfrequenzumwandlung durchführt auf der Grundlage eines Ergebnisses der Auswahl durch die Steuereinheit, wobei die Signalerzeugungseinrichtung ferner umfasst:

eine Mittelungsverarbeitungseinheit (7), die den Abtastfrequenzeinstellungswert mittelt, wobei

die Steuereinheit (3) einen durch die Mittelungsverarbeitungseinheit (7) gemittelten Abtastfrequenzeinstellungswert als den Abtastfrequenzeinstellungswert festlegt, der verwendet wird, um Abgriffskoeffizienten auszuwählen, die von der Filtereinheit (2-0 bis 2-(L-1), 4) zu verwenden sind.

**2.** Signalerzeugungseinrichtung (1) nach Anspruch 1, wobei

die Filtereinheit (2-0 bis 2-(L-1), 4) eine Vielzahl von Filtern (2-0 bis 2-(L-1)) aufweisen, für welche jeweils unterschiedliche Kombinationen von Abgriffskoeffizienten eingestellt sind, und

eine Schalteinheit (4), die eines der Filter (2-0 bis 2-(L-1)) auswählt auf der Grundlage einer Anweisung der Steuereinheit (3), um das ausgewählte Filter als das Ausgangssignal festzulegen, und

die Steuereinheit (3) Abgriffskoeffizienten, die von der Filtereinheit (2-1 bis 2-(L-1), 4) verwendet werden, auswählt durch Bestimmen des durch die Schalteinheit (4) auszuwählenden Filters, auf der Grundlage des Abtastfrequenzeinstellungswerts.

**3.** Signalerzeugungseinrichtung (1) nach Anspruch 1, wobei

die Steuereinheit (3) die Kombinationen von Abgriffskoeffizienten enthält und von der Filtereinheit (2-0 bis 2-(L-1), 4) verwendete Abgriffskoeffizienten auswählt durch Auswählen der Kombination der Filterkoeffizienten, auf der Grundlage des Abtastfrequenzeinstellungswerts,

die Filtereinheit (2-0 bis 2-(L-1), 4) ein Filter aufweist, und

das Filter die Abtastfrequenzumwandlung durchführt unter Verwendung der Kombination der durch die Steuereinheit (3) ausgewählten Abgriffskoeffizienten.

**4.** Signalerzeugungseinrichtung (1) nach Anspruch 2 oder 3, wobei das Filter ein FIR-Filter ist.

**5.** Signalerzeugungseinrichtung (1) nach einem der Ansprüche 1 bis 4, wobei

der Abtastfrequenzeinstellungswert ein Wert ist, der auf der Grundlage eines Verhältnisses zwischen einem Arbeitstakt der Filtereinheit (2-0 bis 2-(L-1), 4) und der Abtastfrequenz des Ausgangssignals berechnet wird.

6. Signalerzeugungseinrichtung (1) nach Anspruch 5, wobei
die Steuereinheit (3) aufweist
eine Phasenerzeugungseinheit (31), die auf der Grundlage des Abtastfrequenzeinstellungswerts eine Phase erzeugt, anzeigend eine Position einer Kombination von Abgriffskoeffizienten, die auszuwählen ist, wenn die Kombinationen von Abgriffskoeffizienten in einer vorherbestimmten Reihenfolge angeordnet sind, und
eine Filtersteuereinheit (3), die von der Filtereinheit verwendete Abgriffskoeffizienten auf der Grundlage der Phase auswählt.

7. Signalerzeugungseinrichtung (1) nach Anspruch 6, wobei die Phasenerzeugungseinheit (31) die Phase als einen Wert erzeugt, derart, dass ein Mindestwert 0 ist und ein Maximalwert eine Gesamtanzahl der Kombinationen von Abgriffskoeffizienten ist.

8. Signalerzeugungseinrichtung (1) nach Anspruch 7, wobei die Phasenerzeugungseinheit (31) die Phase als einen Wert erzeugt, der durch Aufrunden oder Abrunden von Brüchen erhalten wird.

9. Signalerzeugungseinrichtung (1) nach Anspruch 6, 7 oder 8, wobei die Steuereinheit (3) ferner eine Schieberegisterfreigabeerzeugungseinheit (52) aufweist, die ein Schieberegisterfreigabesignal zum Anweisen eines Aktualisierungszeitpunkts des in die Filtereinheit (2-0 bis 2-(L-1), 4) eingegebenen Eingangssignals erzeugt.

10. Signalerzeugungseinrichtung (1) nach Anspruch 9, wobei die Schieberegisterfreigabeerzeugungseinheit (52) das Schieberegisterfreigabesignal erzeugt, um einen Aktualisierungszeitpunkt des Eingangssignals anzuweisen, wenn die Phase gleich wird wie oder größer wird als ein vorherbestimmter Schwellenwert.

11. Signalerzeugungseinrichtung (1) nach Anspruch 1, wobei die Mittelungsverarbeitungseinheit (7) ein IIR-Filter ist.

12. Signalerzeugungseinrichtung (1) nach einem der Ansprüche 1 bis 11, wobei
die Kombinationen der Abgriffskoeffizienten bestimmt sind durch Anwendung von Polyphasenzerlegung auf eine Impulsantwort einer vorherbestimmten Filtereigenschaft.

13. Signalerzeugungsverfahren in einer Signalerzeugungseinrichtung (1), aufweisend Durchführen von Abtastfrequenzumwandlung in Bezug auf ein Eingangssignal einer vorherbestimmten Abtastfrequenz, und Erzeugen eines Signals, das nach der Abtastfrequenzumwandlung erhalten wurde, als ein Ausgangssignal, wobei das Verfahren umfasst:

einen Steuerschritt des Auswählens, auf der Grundlage eines Abtastfrequenzeinstellungswerts, anzeigend eine Abtastfrequenz des Ausgangssignals, einer Kombination von Abgriffskoeffizienten, die von einer Filtereinheit (2-0 bis 2-(L-1), 4) verwendet werden, aus einer Vielzahl von Kombinationen der Abgriffskoeffizienten, die im Voraus bestimmt werden; und
einen Abtastfrequenzumwandlungsschritt des Durchführens der Abtastfrequenzumwandlung auf der Grundlage eines Ergebnisses der Auswahl im Steuerschritt, wobei das Verfahren ferner den Schritt des Mittelns des Abtastfrequenzeinstellungswerts umfasst, wobei
im Steuerschritt ein im Mittelungsschritt gemittelter Abtastfrequenzeinstellungswert als der Abtastfrequenzeinstellungswert festgelegt wird, der verwendet wird, um Abgriffskoeffizienten auszuwählen.

**Revendications**

1. Dispositif de génération de signal (1) comprenant :

une unité de filtrage (2-0 à 2-(L-1), 4) qui met en oeuvre une conversion de fréquence d'échantillonnage par rapport à un signal d'entrée d'une fréquence d'échantillonnage prédéterminée, et génère un signal obtenu après la conversion de fréquence d'échantillonnage sous la forme d'un signal de sortie ; et
une unité de commande (3) qui sélectionne, sur la base d'une valeur de réglage de fréquence d'échantillonnage indiquant une fréquence d'échantillonnage du signal de sortie, une combinaison de coefficients de dérivation utilisée par l'unité de filtrage (2-0 à 2-(L-1), 4) parmi une pluralité de combinaisons de coefficients de dérivation déterminée à l'avance, dans lequel :
l'unité de filtrage (2-0 à 2-(L-1), 4) met en oeuvre la conversion de fréquence d'échantillonnage sur la base d'un résultat de la sélection par l'unité de commande, le dispositif de génération de signal comprenant en outre les :

une unité de traitement de calcul de moyenne (7) qui calcule la moyenne de la valeur de réglage de fréquence d'échantillonnage ; dans lequel
l'unité de commande (3) désigne une valeur de réglage de fréquence d'échantillonnage moyennée par l'unité de traitement de calcul de moyenne (7) en tant qu'une valeur de réglage de fréquence d'échantillonnage utilisée pour sélectionner des coefficients de dérivation devant être utilisés par l'unité de filtrage (2-0 à 2-(L-1), 4).

2. Dispositif de génération de signal (1) selon la revendication 1, dans lequel :

l'unité de filtrage (2-0 à 2-(L-1), 4) inclut :

une pluralité de filtres (2-0 à 2-(L-1)) pour lesquels différentes combinaisons de coefficients de dérivation sont respectivement réglées ; et
une unité de commutation (4) qui sélectionne l'un des filtres (2-0 à 2-(L-1)) sur la base d'une instruction de l'unité de commande (3) de manière à désigner le filtre sélectionné en tant que le signal de sortie ; et

l'unité de commande (3) sélectionne des coefficients de dérivation utilisés par l'unité de filtrage (2-0 à 2-(L-1), 4) en déterminant le filtre devant être sélectionné par l'unité de commutation (4), sur la base de la valeur de réglage de fréquence d'échantillonnage.

3. Dispositif de génération de signal (1) selon la revendication 1, dans lequel :

l'unité de commande (3) maintient les combinaisons de coefficients de dérivation, et sélectionne des coefficients de dérivation utilisés par l'unité de filtrage (2-0 à 2-(L-1), 4) en sélectionnant la combinaison des coefficients de dérivation, sur la base de la valeur de réglage de fréquence d'échantillonnage ;
l'unité de filtrage (2-0 à 2-(L-1), 4) inclut un filtre unique ; et
le filtre met en oeuvre la conversion de fréquence d'échantillonnage en utilisant la combinaison des coefficients de dérivation sélectionnés par l'unité de commande (3).

4. Dispositif de génération de signal (1) selon la revendication 2 ou 3, dans lequel le filtre est un filtre à réponse impulsionnelle finie, FIR.

5. Dispositif de génération de signal (1) selon l'une quelconque des revendications 1 à 4, dans lequel la valeur de réglage de fréquence d'échantillonnage est une valeur calculée sur la base d'un rapport entre une horloge de fonctionnement de l'unité de filtrage (2-0 à 2-(L-1), 4) et la fréquence d'échantillonnage du signal de sortie.

6. Dispositif de génération de signal (1) selon la revendication 5, dans lequel :
l'unité de commande (3) inclut :

une unité de génération de phase (31) qui génère, sur la base de la valeur de réglage de fréquence d'échantillonnage, une phase indiquant une position d'une combinaison de coefficients de dérivation à sélectionner lorsque les combinaisons de coefficients de dérivation sont agencées dans un ordre prédéterminé ; et
une unité de commande de filtre (3) qui sélectionne des coefficients de dérivation utilisés par l'unité de filtrage (2-0 à 2-(L-1)) sur la base de la phase.

7. Dispositif de génération de signal (1) selon la revendication 6, dans lequel l'unité de génération de phase (31) génère la phase sous la forme d'une valeur telle qu'une valeur minimale est égale « 0 » et qu'une valeur maximale correspond à un nombre total des combinaisons de coefficients de dérivation.

8. Dispositif de génération de signal (1) selon la revendication 7, dans lequel l'unité de génération de phase (31) génère la phase sous la forme d'une valeur obtenue en arrondissant, ou en arrondissant au chiffre inférieur, des fractions.

9. Dispositif de génération de signal (1) selon la revendication 6, 7 ou 8, dans lequel l'unité de commande (3) inclut en outre une unité de génération de signal d'activation de registre à décalage (52) qui génère un signal d'activation de registre à décalage pour instruire une temporisation de mise à jour du signal d'entrée qui est appliqué en entrée dans l'unité de filtrage (2-0 à 2-(L-1), 4).

**10.** Dispositif de génération de signal (1) selon la revendication 9, dans lequel l'unité de génération de signal d'activation de registre à décalage (52) génère le signal d'activation de registre à décalage afin d'instruire une temporisation de mise à jour du signal d'entrée lorsque la phase devient égale ou supérieure à un seuil prédéterminé.

**11.** Dispositif de génération de signal (1) selon la revendication 1, dans lequel l'unité de traitement de calcul de moyenne (7) correspond à un filtre à réponse impulsionnelle infinie, IIR.

**12.** Dispositif de génération de signal (1) selon l'une quelconque des revendications 1 à 11, dans lequel les combinaisons des coefficients de dérivation sont déterminées en appliquant une décomposition polyphasée à une réponse impulsionnelle d'une caractéristique de filtrage prédéterminée.

**13.** Procédé de génération de signal dans un dispositif de génération de signal (1) incluant l'étape consistant à mettre en oeuvre une conversion de fréquence d'échantillonnage par rapport à un signal d'entrée d'une fréquence d'échantillonnage prédéterminée, et l'étape consistant à générer un signal obtenu après la conversion de fréquence d'échantillonnage, sous la forme d'un signal de sortie, le procédé comprenant :

une étape de commande consistant à sélectionner, sur la base d'une valeur de réglage de fréquence d'échantillonnage indiquant une fréquence d'échantillonnage du signal de sortie, une combinaison de coefficients de dérivation utilisée par l'unité de filtrage (2-0 à 2-(L-1), 4) parmi une pluralité de combinaisons de coefficients de dérivation déterminée à l'avance ; et

une étape de conversion de fréquence d'échantillonnage consistant à mettre en oeuvre la conversion de fréquence d'échantillonnage sur la base d'un résultat de la sélection à l'étape de commande, le procédé comprenant en outre l'étape consistant à calculer la moyenne de la valeur de réglage de fréquence d'échantillonnage ; dans lequel

à l'étape de commande, une valeur de réglage de fréquence d'échantillonnage moyennée à l'étape de calcul de moyenne est désignée en tant que la valeur de réglage de fréquence d'échantillonnage utilisée pour sélectionner des coefficients de dérivation.

# FIG.1

# FIG.2

# FIG.3

TAP COEFFICIENTS

|  | C0 | C1 | C2 | C3 | C4 |
|---|---|---|---|---|---|
| $H_0$ | h(0, 0) | h(0, 1) | h(0, 2) | h(0, 3) | h(0, 4) |
| $H_4$ | h(4, 0) | h(4, 1) | h(4, 2) | h(4, 3) | h(4, 4) |
| $H_8$ | h(8, 0) | h(8, 1) | h(8, 2) | h(8, 3) | h(8, 4) |
| $H_{12}$ | h(12, 0) | h(12, 1) | h(12, 2) | h(12, 3) | h(12, 4) |

FIG.4-1

FIG.4-2

FIG.4-3

FIG.4-4

FIG.4-5

# FIG.5

# FIG.6

EP 2 528 231 B1

# FIG.7

SET NUMBER OF TAP COEFFICIENTS: $H_0$ $H_4$ $H_8$ $H_{12}$ $H_1$ $H_5$ $H_9$ $H_{13}$ $H_2$ $H_6$ $H_{10}$ $H_{14}$ $H_3$ $H_7$ $H_{11}$ $H_{15}$

PHASE: 0  4  8  12  1  5  9  13  2  6  10  14  3  7  11  15

OUTPUT FROM PHASE GENERATION UNIT
PHASE CHANGE (0 TO N-1)
THRESHOLD $\alpha$

HIGH-SPEED CLOCK

SHIFT REGISTER ENABLE

EP 2 528 231 B1

# FIG.8

SET NUMBER OF TAP COEFFICIENTS

PHASE

OUTPUT FROM PHASE GENERATION UNIT PHASE CHANGE (0 TO N-1)

THRESHOLD $\alpha$

HIGH-SPEED CLOCK

SHIFT REGISTER ENABLE

# FIG.9

INPUT SAMPLE DATA

HIGH-SPEED CLOCK

SAMPLING FREQUENCY SETTING (PHASE)

SHIFT REGISTER — 10

TAP-COEFFICIENT GENERATION UNIT — 53

SHIFT-REGISTER ENABLE GENERATION UNIT — 52

PHASE GENERATION UNIT — 51

COEFFICIENT MULTIPLICATION UNIT — 13

ADDER — 12

SAMPLING FREQUENCY CONVERSION DATA

SIGNAL GENERATION DEVICE — 1a

5

2

EP 2 528 231 B1

# FIG.10

# FIG.11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6014682 A
- JP H0221712 A
- US 2006179095 A1
- US 2002140853 A1
- US 7072429 B1

**Non-patent literature cited in the description**

- **NISHIMURA.** Communication system design by digital signal processing. CQ Publishing Co., Ltd, June 2006, 79-89